Europäisches Patentamt

(19) European Patent Office

Office européen des brevets

(11) Publication number: **0 121 314**
**B1**

(12) **EUROPEAN PATENT SPECIFICATION**

(45) Date of publication of patent specification: 24.08.88

(51) Int. Cl.⁴: **C 01 B 21/06, C 23 C 14/00**

(21) Application number: **84301185.9**

(22) Date of filing: **23.02.84**

(54) **High hardness hafnium nitride.**

(30) Priority: **04.04.83 US 481952**

(43) Date of publication of application:
**10.10.84 Bulletin 84/41**

(45) Publication of the grant of the patent:
**24.08.88 Bulletin 88/34**

(84) Designated Contracting States:
**AT CH DE FR GB IT LI SE**

(56) References cited:
THIN SOLID FILMS, vol. 63, no. 2, November
1979, pages 327-331, Elsevier Sequoia SA, NL;
R. NIMMAGADDA et al: "High rate deposition
of hafnium nitride by activated reactive
evaporation (are)"

THIN SOLID FILMS, vol. 63, no. 2, November
1979, pages 289-297, Elsevier Sequoia SA, NL;
R.G. DUCKWORTH et al.: "Ion bombardment of
group IV elemental metal and synthetic nitride
films"

JOURNAL OF APPLIED PHYSICS, vol. 41, no.
10, September 1970, pages 4227-4231; F.T.J.
SMITH: "Structure and electrical properties of
sputtered films of hafnium and hafnium
compounds"

(73) Proprietor: **BORG-WARNER CORPORATION**
**200 South Michigan Avenue**
**Chicago Illinois 60604 (US)**

(72) Inventor: **Sproul, William Dallas**
**500, S. Bristol Court**
**Palatine Illinois 60067 (US)**

(74) Representative: **Williams, Trevor John et al**
**J.A. KEMP & CO. 14 South Square Gray's Inn**
**London WC1R 5EU (GB)**

(56) References cited:
THIN SOLID FILMS, vol. 96, no. 1, October 1982,
pages 87-91, Elsevier Sequoia, NL; P.R. ARON
et al.: "Some properties of R.F.-sputtered
hafnium nitride coatings"

PATENTS ABSTRACTS OF JAPAN, vol. 5, no.
152 (C-73) 824r, 25th September 1981

PATENTS ABSTRACTS OF JAPAN, vol. 2, no.
126, 21st October 1978, page 2587 C 78

Courier Press, Leamington Spa, England.

**Description**

The present invention relates to the rapid rate reactive sputtering of hafnium nitride onto a substrate or workpiece and to the resulting high hardness coating material. Methods for the coating of a metallic layer or a metallic compound onto a substrate include vapor deposition, plasma spray processes and cathode sputtering. Vapor deposition processes to provide a metallic thin film on a workpiece utilize the material for plating in a suitable atmosphere, such as a vacuum or an inert shielding gas, wherein the material is heated until it evaporates and is deposited as a film on a substrate.

Plasma spray processes provide the material to be deposited in the form of a fine-grained powder which is brought into a plasma arc so that the particles melt and are deposited on the substrate.

Cathodic magnetron sputtering or radio-frequency ionic sputtering involves a metallic target formed of the material to provide the desired coating on the substrate or workpiece in a gas discharge wherein the material is sputtered by ion bombardment; the metallic particles removed from the target being deposited on the substrate. The target becomes the cathode and the anode is located beneath the substrate. Where a thin film of metallic compounds, such as the oxides, nitrides, carbides or the like, are to be deposited on various substrates, reactive sputtering is utilized wherein the target consists of the metal for the plating compound and a neutral or inert gas, such as argon, is mixed with a reactive gas such as oxygen, nitrogen or methane. The particles dislodged from the target combine with the reactive gas to produce the desired compound which is deposited on the substrate or workpiece.

In the use of carbide or high speed steel tool bits for cutting or similar operations, wear becomes a substantial problem along with the ability to be resharpened or reground. To enhance the wear life of a cutting tool edge, the cutting surfaces are coated with a thin film of a wear resistant material, such as titanium carbide or titanium nitride. The present invention relates to an improved high hardness coating that will substantially increase the wear life of tools and other functional articles that require protection from wear.

The present invention comprehends the provision of an improved high hardness metallic compound that can be deposited on the surface of an article to substantially enhance the wear properties of the article.

In pages 327—331 of Thin Solid Fibres, vol. 63, No. 2, upon which the prior art portion of claim 1 has been based, there is disclosed that hafnium nitride particles deposited on a surface by sputtering have a larger cell size and a greater hardness than bulk hafnium nitride. The applications of similar hard films of hafnium nitride to a substrate are disclosed in pages 289—297 of Thin Solid Fibres, vol. 63, No. 2; pages 4227—4231 of Journal of Applied Physics, vol. 41, pages 87 to 91 of Thin Solid Fibres, vol. 96, No. 1 and page 2587 C78 of Patents Abstracts of Japan, vol. 2, No. 126. While from this prior art it can be learned that harder hadnium nitride coatings with enlarged cells size can be obtained using a sputtering technique an object of the present invention is to provide a substrate having a still harder and more advantageous hafnium nitride coating.

The present invention, as defined in the claims, provides a hafnium nitride coating that has an approximately 1% larger lattice spacing than that for bulk hafnium nitride with the hardness of the coating in the range of 65 to 69% greater than the hardness of the bulk material.

The present invention further comprehends the provision of a high hardness coating of hafnium nitride formed during a magnetron cathodic reactive sputtering process utilizing a hafnium target, an inert atmosphere of argon and a controlled quantity of nitrogen which reacts with the hafnium to deposit the high hardness coating on the substrate or workpiece.

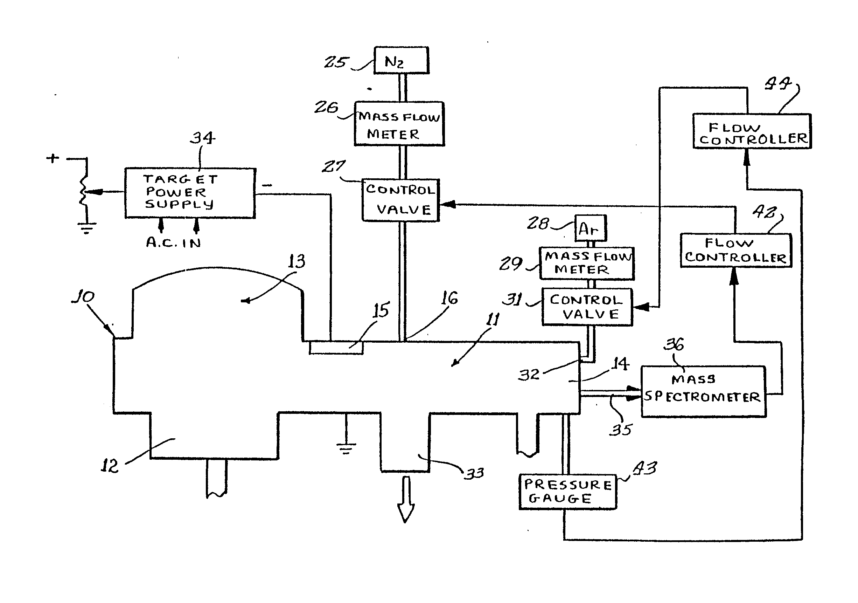

The drawing figure shows a schematic view of a magnetron sputtering apparatus utilized to produce the high hardness coating of the present invention and control therefor.

Referring more particularly to the disclosure in the drawing wherein is shown an illustrative embodiment of reactive sputtering apparatus 10 for the plating of a thin film of hafnium nitride (HfN) on a suitable substrate. The apparatus includes an elongated chamber 11 having an elevator at one end 12 communicating with a domed loading/unloading chamber 13, a pellet which is carried by the elevator to receive the substrate to be coated, a pallet carrier receiving the pallet from the elevator and moving the pallet into the chamber 11 for sputtering in the central portion and/or etching on a platform at the end 14 of the chamber opposite to the elevator.

A magnetron cathode 15 in the chamber carries a target formed of hafnium metal and is located in the upper wall of the chamber 11. A substantially rectangular ring of tubing having a plurality of openings therein directed downwardly and inwardly for a purpose to be later described is positioned encompassing the periphery of the target. The tubing ring is connected to an inlet 16 in the upper wall for communication with a source 25 of nitrogen gas. The gas source is connected to the inlet through a mass flow meter 26 and a control valve 27.

A source 28 of argon gas communicates with an inlet 32 in the chamber end 14 through a second mass flow meter 29 and a control valve 31. Also, an outlet 33 in the floor of the chamber 11 is connected to a vacuum system for evacuation of the chamber to draw all air and other contaminants out prior to etching and sputtering. A horizontally moving shutter plate (not shown) having an opening or shutter therein may be utilized below the target to prevent any substantial scattering of material onto other portions of the chamber, thus directing the material onto the substrate below the opening.

Vacuum is continuously applied to the chamber 11 to draw all air and contaminants out through the outlet 33, and a substrate is loaded onto a carrier pallet in the domed chamber 13; which chamber is then sealed and evacuated. The elevator lowers the pallet onto a carrier which is shifted to the opposite end 14 of the chamber 11, and the elevator is raised to seal the domed chamber 13 from the main processing chamber 11. A throttle (not shown) is operated to close the outlet 33, and argon gas is admitted through the flow meter 29, control valve 31 and inlet 32 to backfill the chamber 11 with a partial pressure of argon. A pressure gauge 43 measures the pressure of the argon and provides a signal to a flow controller 44, which in turn signals the control valve 31 to maintain a constant pressure of 1.066 Pa (8 millitorr) in the chamber.

A potential is applied to the substrate at the etching station, and the argon gas ionizes to provide argon ions which bombard the substrate to clean the surface to be coated. Once cleaned, the potential is interrupted and the substrate is shifted to a position beneath the hafnium target and cathode 15, and nitrogen gas is then admitted through the mass flow meter 26, control valve 27 and inlet 16 to be directed downward by the tubing ring to the substrate. A potential of a negative 450 to 500 volts is applied to the cathode 15 from a target power supply 34 and a bias voltage of minus 80 to 100 volts is applied to the substrate, whereupon the resulting argon ions bombard the hafnium target. The hafnium atoms displaced by the bombardment pass downward with the nitrogen gas to react and form hafnium nitride onto the cleaned surface of the substrate. Once the desired thickness of hafnium nitride has been achieved, the potential is interrupted and the substrate removed through the domed chamber 13.

A sampling tube 35 at the chamber end 14 provides a mass spectrometer 36 with a gas sample indicating the amount of excess (unreacted) nitrogen gas remaining in the chamber during sputtering. The nitrogen peak on the mass spectrometer screen is measured and a signal is generated to a flow controller 42 which in turn provides a signal to the nitrogen control valve 27 to control the partial pressure of the nitrogen in the chamber substantially continuously during the sputtering cycle. A more complete description of the sputtering operation and control circuits therefor is found in our co-pending EP—A—0121019.

The sputtering reaction was carried out in a Materials Research Corporation (MRC) 902M In-Line sputtering system with both DC and RF magnetron, RF etch, and DC bias capabilities. Targets of hafnium and titanium and zirconium, for comparison, were MRC VP grade materials. Hafnium nitride was reactively sputtered from both a bonded planar hafnium target and from a Research S-Gun adapted to the MRC machine. Titanium nitride was reactively sputtered from both Inset and bonded planar titanium targets, and zirconium nitride from a zirconium Inset target. The target to substrate distance was 7.6 cm (3″).

Argon was bled into the machine at a pressure in the range of 0.533 to 1.866 Pa (4.0 to 14.0 millitorr), although a preferred pressure is 1.066 Pa (8.0 millitorr). Nitrogen gas is admitted at an optimum flow rate based on the power applied to the target as shown in the following table.

TABLE I

| Target power—kW | $N_2$ Flow, sccm* |
|---|---|
| 1.0 | 5.3 |
| 2.0 | 10.6 |
| 3.0 | 15.9 |
| 4.0 | 20.2 |
| 5.0 | 24.6 |

*standard cubic centimeters per minute.

The nitrogen and argon gas flows were controlled with MKS 260 flow controllers, and the chamber gas composition during sputtering was monitored with a UTi (Uthe Technology International) Model 100C mass spectrometer. The temperature of samples immediately emerging from the sputtering reaction never exceeded 315°C (600°F).

The hafnium nitride coating was deposited on several substrates with similar results. The substrates included Corning 7059 borosilicate glass slides, pieces of M-2 tool steel hardened to Rc65, and Valemite VC-2 carbide cutting tool inserts. Also, wear rings made from SAE 4620 carburized steel were coated with hafnium nitride; the coating thickness in all instances being in the range of 4.0 to 5.0 µm. As examples of the deposition rates for hafnium nitride, to provide a coating thickness of approximately 3500 angstroms (Å), a scanning rate of the substrate under the shutter for the target was 25.4 cm (10.0″) per minute for a target power of 6.0 kilowatts (kw). For a stationary substrate, the deposition rate of hafnium nitride was 2950 Å per minute at 5.0 kw target power.

The sputter coated hafnium nitride was found to have a higher hardness compared with the bulk material. Utilizing a standard Vickers microindentation hardness test, the following table discloses the

3

**0 121 314**

hardness of the hafnium nitride coating compared to other known group IVb metallic nitrides in bulk and sputter coated forms.

TABLE II

| Vickers hardness (optical) | Bulk | Sputter coated |
|---|---|---|
| TiN | 2000 kg/mm$^2$ | 2650 kg/mm$^2$ |
| ZrN | 1500 | 2350 |
| HfN | 1600 | 4200 |

It was found that there is a variation in hardness readings for optical versus scanning electron microscope (SEM) readings of the Vickers Hardness at 100 gms and 200 gms load for the three materials as shown in the following table.

TABLE III

| Material | Optical | SEM |
|---|---|---|
| TiN (100 gms) | 3200 kg/mm$^2$ | 2350 kg/mm$^2$ |
| TiN (200 gms) | 2650 | 2400 |
| ZrN (100 gms) | 3350 | 2625 |
| ZrN (200 gms) | 2350 | 2500 |
| HfN (100 gms) | 5510 | 3110 |
| HfN (200 gms) | 4200 | 2700 |

With respect to the hafnium nitride coating from the sputtering process, not only is the hardness 68% greater over the bulk materials from values found in the literature, but the cell size has an increase in the lattice spacing for the face centered cubic structure of approximately 1% as follows:

TABLE IV

| Property | Bulk HfN | CVD HfN | Sputtered HfN |
|---|---|---|---|
| Cell size-Å | 4.52 | 4.51 | 4.55—4.58 |

Also, conventionally as the amount of nitrogen in bulk hafnium nitride increases, the cell size decreases. However, in the sputtered material, as nitrogen increases, the cell size also increases. Thus, the sputtered hafnium nitride provides a final coating of higher hardness and increased cell size compared to titanium nitride and zirconium nitride which, although having an increased hardness, do not have any change in the cell size of the sputter coated material over the bulk material. All three nitrides have face centered cubic structures. Obviously, the Vickers hardness values are an average of several readings at each of the testing loads for both the optical and scanning electron microscope readings.

**Claims**

1. A high hardness hafnium nitride having a face centered cubic structure which has been obtained by sputtering a nitride coating on a suitable substrate, characterised in that it has a cell size of 4.55 to 4.58 Å and a hardness in the range of 2700 to 4200 kg/mm$^2$ for Vickers microindentation hardness and the temperature of the nitride during the sputter coating has not been allowed to exceed 315°C (600°F).

2. A high hardness hafnium nitride as set forth in claim 1, wherein the coating has been formed in an evacuated chamber containing argon in a pressure range of 0.533 to 1.866 Pa (4 to 14 millitorr) and in which nitrogen has been fed at a rate of 12.1 to 31.5 standard cm$^3$/min.

3. A high hardness hafnium nitride as set forth in claim 2, which has been obtained by the sputtering process in which the power to the hafnium target has been maintained in the range of 1.0 to 6.0 kilowatts with a bias of minus 80 to 100 volts having been applied to the substrate.

4

4. A high hardness hafnium nitride as set forth in claim 2 or 3, which has been obtained with the argon pressure during coating having been 1.066 Pa (8.0 millitorr).

5. A high hardness hafnium nitride as set forth in any preceding claim, which has been obtained with the sputtering having been carried out in a magnetron-type sputtering apparatus.

**Patentansprüche**

1. Hochhartes Hafniumnitrid mit kubischflächenzentrierter Struktur, das man durch Kathodenzerstäubung eines Nitridüberzuges auf ein geeignetes Substrat erhält, dadurch gekennzeichnet, daß es eine Zellgröße von 4,55 bis 4,58 Å und eine über das Mikrohärteprüfverfahren nach Vickers ermittelte Härte von 2700 bis 4200 kg/mm$^2$ aufweist und daß die Temperatur des Nitrids während des Zerstäubens nicht über 315°C (600°F) steigt.

2. Hochhartes Hafniumnitrid nach Anspruch 1, bei dem der überzug in einer evakuierten Kammer gebildet wurde, die zwischen 0,533 bis 1,866 Pa (4 bis 14 Millitorr) Argon enthält und in die zwischen 12,1 bis 31,5 Standard cm$^3$/min Stickstoff eingeleitet werden.

3. Hochhartes Hafniumnitrid nach Anspruch 2, das durch Kathodenzerstäubung gebildet wird, wobei die Leistung der Hafniumstrahlungselektrode in einem Bereich von 1,0 bis 6,0 Kilowatt gehalten wird und .an das Substrat eine Vorspannung von minus 80 bis 100 Volt angelegt wird.

4. Hochhartes Hafniumnitrid nach den Ansprüchen 2 oder 3, das bei einem Argondruck von 1,066 Pa (8,0 Millitorr) gebildet wird.

5. Hochhartes Hafniumnitrid nach einem der vorhergehenden Ansprüche, das durch Kathodenzerstäubung in einer Vorrichtung vom Magnettron-Typ gebildet wird.

**Revendications**

1. Nitrure d'hafnium de dureté élevée comportant une structure cubique à faces centrées, qu'on peut obtenir en pulvérisant un revêtement de nitrure sur un substrat approprié, caractérisé en ce qu'il a une taille des cellules de 4,55 à 4,58 Å et une dureté comprise entre 2700 et 4200 kg/mm$^2$ pour la dureté par micro-enfoncement Vickers et en ce qu'on ne laisse pas la température de nitrure pendant le revêtement par pulvérisation dépasser 315°C.

2. Nitrure d'hafnium de dureté élevée selon la revendication 1, dans lequel le revêtement est formé dans une chambre sous vide contenant de l'argon à une pression comprise entre 0,533 et 1,866 Pa et dans laquelle de l'azote a été introduit à un débit de 12,1—31,5 cm$^3$/min.

3. Nitrure d'hafnium de dureté élevée selon la revendication 2, qu'on a obtenu par le procédé du pulvérisation dans lequel la puissance appliquée à la cible d'hafnium a été maintenue entre 1,0 et 6,0 kilowatts avec une polarisation de moins 80 à 100 volts appliquée au substrat.

4. Nitrure d'hafnium de dureté élevée selon la revendication 2 ou la revendication 3, qu'on a obtenu avec la pression d'argon pendant le revêtement égale à 1,066 Pa.

5. Nitrure d'hafnium de dureté élevée selon l'une quelconque des revendications précédentes, qu'on a obtenu avec la pulvérisation effectuée dans un appareil de pulvérisation du type magnétron.

25 N₂

26 MASS FLOW METER

27 CONTROL VALVE

34 TARGET POWER SUPPLY

+

−

A.C. IN

44 FLOW CONTROLLER

28 Ar

29 MASS FLOW METER

31 CONTROL VALVE

42 FLOW CONTROLLER

13

10

15

16

11

32

14

36 MASS SPECTROMETER

35

12

33

43 PRESSURE GAUGE